# EUROPÄISCHE PATENTSCHRIFT

(11) **EP 2 594 669 B1**
(45) Veröffentlichungstag und Bekanntmachung des Hinweises auf die Patenterteilung: **29.03.2017**
(21) Anmeldenummer: 12007119.6
(22) Anmeldetag: 13.10.2012
(51) Int. Cl.: D01H 13/00, D01H 11/00, H05K 7/20, F04D 29/70

(54) **Schaltschrank für eine Textilmaschine**
Control cabinet for a textile machine
Armoire électrique pour une machine textile

(30) Priorität: 19.11.2011 DE 102011118983
(43) Veröffentlichungstag der Anmeldung: 22.05.2013
(73) Patentinhaber: Saurer Germany GmbH & Co. KG, 42897 Remscheid (DE)
(72) Erfinder: Krawietz, Stefan, 73061 Ebersbach/Fils (DE)

(56) Entgegenhaltungen:
- EP-A2- 1 798 492
- DE-A1- 19 915 235
- US-A- 5 807 415

## Beschreibung

Die Erfindung betrifft einen Schaltschrank für eine Textilmaschine zur Aufnahme von elektrischen Komponenten. Der Schaltschrank weist eine Öffnung für Zuluft, eine Öffnung für Abluft, einen Ventilator zur Zwangsförderung von Luft durch die Öffnung für Zuluft in den Schaltschrank und einen Filtersieb zur Reinigung der Zuluft auf.

Im Bereich der Textilmaschinen sind Schaltschränke und die darin angeordneten Betriebsmittel, wie elektronische Komponenten, im Vergleich zu anderen Anwendungen besonderen Anforderungen ausgesetzt. Die Luft in Textilmaschinensälen ist mit verhältnismäßig viel Faserflug durchsetzt, der durch Fasern, Faserbündel, Fadenreste, Staub und sonstige lange in der Luft schwebend bleibende Textilreste gebildet wird, die an den Textilmaschinen freigesetzt werden. Solche Textilmaschinen, die viel Faserflug in die Luft freisetzen, sind zum Beispiel Karden, Strecken, Flyer, Spinnmaschinen, Kämmereimaschinen, Webmaschinen, Zwirnmaschinen oder Spulmaschinen.

Die EP 1 798 492 A2 offenbart eine Filter-Ventilator-Einheit mit einem Gehäuse, in dem wenigstens ein Ventilator untergebracht ist, und mit mindestens einem Filter. Das Gehäuse ist aus einer Transport/Lagerstellung mit kleinem Volumen in eine Gebrauchslage mit großem Volumen überführbar. Die Filter-Ventilator-Einheit soll vorzugsweise im Deckenbereich von Reinräumen zur Anwendung kommen.

Die DE 199 15 235 A1 offenbart einen gattungsgemäßen Schaltschrank mit einer Belüftungseinrichtung zur Kühlung des Schaltschrankes beziehungsweise der in dem Schaltschrank angeordneten elektrischen Komponenten. Die Kühlung ist erforderlich, um die Verlustwärme der elektrischen Komponenten abzuführen. Da, wie oben erläutert, die Luft in Textilmaschinensälen stark mit Faserflug verunreinigt ist, wird die für die Kühlung erforderliche Zuluft, die in den Schaltschrank oder zumindest in Teile des Schaltschrankes eindringt, gefiltert. Auf diese Weise kann zwar verhindert werden, dass die in dem Schaltschrank angeordneten elektrischen Komponenten verschmutzen oder dass sich ein zur verbesserten Abfuhr vorgesehener Kühlkörper mit Faserflug zusetzt, es ist jedoch unvermeidlich, dass sich die Siebe des Filters mit Faserflug zusetzen. Der Belag aus Fasern und Staub führt dazu, dass der Zuluftstrom behindert wird und zu einer verminderten Kühlung führt. Eine regelmäßige Reinigung der Filtersiebe ist also unbedingt erforderlich.

Die DE 199 15 235 A1 offenbart eine Vorrichtung zur automatisierten Reinigung des Filters. Dazu ist an der Öffnung für die Zuluft eine Düse auf der Innenseite der Öffnung entgegen der Strömungsrichtung der Zuluft gegen das Filter gerichtet, wobei getaktet Luft von einer Druckluftquelle gegen die Innenseite des Filters geleitet wird, wodurch außen an der Öffnung anhaftende Faserflugpolster entfernt werden. Durch die automatisierte Reinigung können Reinigungsintervalle zwar verkürzt und damit die Verschmutzung vermindert, die Intervalle können aber nicht beliebig verkürzt werden, da die Reinigungsdüse dem Zuluftstrom entgegenwirkt und damit die Zuluft ebenfalls vermindern würde. Eine gewisse Verschmutzung und damit eine Reduzierung der Zuluft läßt sich also auch mit dieser Lösung nicht verhindern.

Es ist daher die Aufgabe der vorliegenden Erfindung, einen Schaltschrank für eine Textilmaschine zu schaffen, bei dem die zur Kühlung erforderliche Zuluft nicht durch die Verschmutzung des Filters abnimmt.

Die Aufgabe wird erfindungsgemäß durch die kennzeichnenden Merkmale des Anspruches 1 gelöst. Vorteilhafte Weiterbildungen der Erfindung sind Gegenstand der Unteransprüche.

Ein erfindungsgemäßer Schaltschrank kann ein erfindungsgemäßes Anbauelement gemäß dem Anspruch 8 und ein bekanntes Schaltschrankelement umfassen, wobei das Anbauelement mit dem Schaltschrank verbunden wird.

Zur Lösung der Aufgabe ist das Filtersieb als Mantelfläche einer kreiszylindrischen Anordnung ausgebildet. Die Öffnung für Zuluft ist im Bereich der Deckfläche dieser kreiszylindrischen Anordnung angeordnet und der Ventilator ist im Bereich der Öffnung für Zuluft so angeordnet und ausgebildet, dass er Luft durch das Filtersieb in den Schaltschrank drückt. Die Zuluft wird dabei aus dem Inneren der kreiszylindrischen Anordnung durch das Filter transportiert. Die Grundfläche ist zumindest teilweise offen. So können Schmutz und Fasern aus dem Bereich des Filters heraustransportiert werden.

Durch die erfindungsgemäße Anordnung wird erreicht, dass die Luft innerhalb der kreiszylindrischen Anordnung rotiert. Die Luft tritt damit nicht senkrecht auf die zylindrische Filterfläche auf, sondern tangential. Die Luft kann trotzdem ungehindert durch das Filter treten. Das Filter verhindert, dass Faserflug, der sich in der Luft befindet und auf das Filter trifft, in das Schaltschrankinnere eintritt. Im Unterschied zum Stand der Technik wird jedoch der Faserflug, der auf das Filtersieb trifft, nicht gegen dasselbe gedrückt und bleibt auch nicht an dem Sieb hängen, sondern der Faserflug wird von der rotierenden Luft mitgenommen. Durch die Blasluft des Ventilators gelangt der Faserflug bis an das dem Ventilator gegenüberliegende Ende der kreiszylindrischen Anordnung. Das Filtersieb wird also durch die rotierende Zuluft ständig gereinigt. Eine Verschmutzung des Filters kann gar nicht erst auftreten. Damit wird der Zuluftstrom auch nicht verschmutzungsbedingt verringert. Durch den beschriebenen selbstreinigenden Effekt sind keine zusätzlichen Einrichtungen für die Reinigung des Filters erforderlich.

Bei einer herkömmlichen Filteranordnung erhöht sich bei einem verschmutzten Filter die Leistungsaufnahme des Ventilators, so dass der Ventilator mit einer ausreichenden Leistungsreserve ausgestattet sein muss, um einen durchgängigen Betrieb zu ermöglichen. Da das Filter gemäß der vorliegenden Erfindung nicht mehr verschmutzt, ist die Leistungsreserve des Ventilators nicht mehr erforderlich. Der Ventilator kann somit für eine geringere Leistung ausgelegt werden.

Gemäß einer vorteilhaften Ausführungsform ist das Filtersieb in dem Schaltschrank so angeordnet, dass die Achse der kreiszylindrischen Anordnung in der Betriebsstellung des Schaltschrankes senkrecht verläuft und der Ventilator am oberen Ende der kreiszylindrischen Anordnung positioniert ist.

Bei einer solchen Anordnung wird die Abfuhr des Faserfluges durch die Gravitation unterstützt und der Faserflug fällt unweigerlich in Richtung der Grundfläche der kreiszylindrischen Anordnung, die der Deckfläche beziehungsweise dem Ventilator gegenüberliegt.

Vorteilhafterweise grenzt an die zumindest teilweise offene Grundfläche der kreiszylindrischen Anordnung ein Raum zur Aufnahme von Faserflug an. In dem Fall, dass die Achse der kreiszylindrischen Anordnung senkrecht verläuft, befindet sich der verschließbare Raum unterhalb des Filters.

Durch eine verschließbare Öffnung ist es leicht möglich, den Faserflug von Zeit zu Zeit aus dem Raum zu entfernen.

Gemäß einer bevorzugten Ausführungsform weist der Schaltschrank ein Schaltschrankelement zur Aufnahme der elektrischen Komponenten und ein Anbauelement auf, welches an einer Seitenwand des Schaltschrankelementes montiert ist, wobei das Filtersieb und der Ventilator in dem Anbauelement angeordnet sind.
Die Öffnung für Abluft ist vorteilhafterweise im Bereich des Schaltschrankelementes angeordnet, so dass das Schaltschrankelement mit den elektrischen Komponenten von der Kühlluft durchströmt wird.

Damit die durch den Filter gedrückte Luft von dem Anbauelement in das Schaltschrankelement gelangen kann, weist das Anbauelement und das Schaltschrankelement zueinander korrespondierende Öffnungen.

Die Erfindung betrifft außerdem das Anbauelement zur Montage an eine Seitenwand eines Schaltschrankelementes mit einem Filtersieb, das als Mantelfläche einer kreiszylindrischen Anordnung ausgebildet ist, und mit einem Ventilator, der im Bereich der Deckfläche der kreiszylindrischen Anordnung angeordnet und so ausgebildet ist, dass er Luft aus dem Inneren der kreiszylindrischen Anordnung durch das Filtersieb nach außen drückt, wobei eine Seite des Anbauelementes eine Öffnung aufweist und das Anbauelement mit dieser Seite an eine Seitenwand eines Schaltschrankelementes montierbar ist.

Das Schaltschrankelement weist dann eine zur Öffnung des Anbauelementes korrespondierende Öffnung auf. So kann der Luftaustausch zwischen dem Anbauelement und dem Schaltschrankelement sichergestellt werden.

Die Grundfläche der kreiszylindrischen Anordnung des Anbauelementes ist zumindest teilweise offen. An die zumindest teilweise offene Grundfläche der kreiszylindrischen Anordnung grenzt vorzugsweise ein Raum zur Aufnahme von Faserflug an.

Damit der Faserflug aus dem Raum des Anbauelementes zur Aufnahme von Faserflug entfernt werden kann, weist dieser eine verschließbare Öffnung auf.

Die Achse der kreiszylindrischen Anordnung des Anbauelementes ist vorzugsweise parallel zu der Seite des Anbauelementes positioniert, die an die Seitenwand eines Schaltschrankelementes montierbar ist. So wird erreicht, dass nach der Montage des Anbauelementes die Achse der kreiszylindrischen Anordnung senkrecht verläuft.

Die Erfindung wird nachfolgend anhand eines in den Zeichnungen dargestellten Ausführungsbeispiels näher erläutert.

Es zeigen:
- Fig. 1: einen erfindungsgemäßen Schaltschrank;
- Fig. 2: ein erfindungsgemäßes Anbauelement.

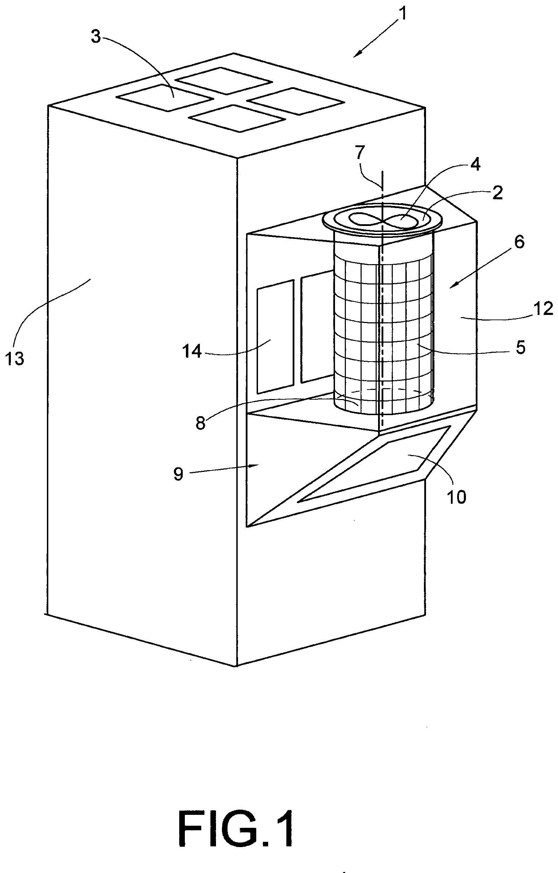

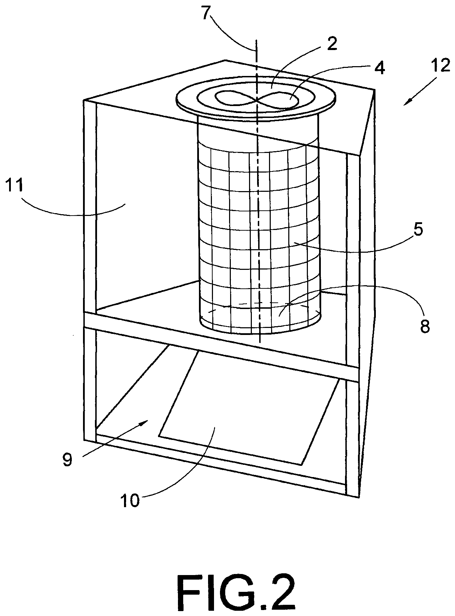

Die Fig. 1 zeigt eine mögliche Ausführungsform eines erfindungsgemäßen Schaltschrankes 1, der ein Schaltschrankelement 13 und ein Anbauelement 12 umfasst. In dem Schaltschrankelement 13 sind hier nicht dargestellte elektrische Komponenten angeordnet. An das Schaltschrankelement 13 ist ein Anbauelement 12 montiert. Das Anbauelement 12 ist in nicht montiertem Zustand in Fig. 2 dargestellt, wobei das Anbauelement in Fig. 2 von der Seite zu sehen ist, die an das Schaltschrankelement 13 montiert wird.

Zur Kühlung der elektrischen Komponenten in dem Schaltschrankelement 13 wird Luft durch die Öffnung 2 des Anbauelementes 12 mittels des Ventilators 4 eingesaugt. Die angesaugte Zuluft wird von dem Ventilator 4 durch das Filtersieb 5 gedrückt. Die Luft gelangt durch die Öffnung 14 zwischen dem Anbauelement 12 und dem Schaltschrankelement 13 in das Schaltschrankelement 13. Die durch die Abwärme der elektrischen Komponenten erwärmte Luft kann durch die Öffnungen 3 im oberen Bereich des Schaltschrankelementes 13 entweichen.

Durch die Öffnung 2, das Filtersieb 5 und die Grundfläche 8 wird eine kreiszylindrische Anordnung 6 gebildet. Das Filter 5 bildet dabei die Mantelfläche und die Öffnung 2 die Deckfläche. Durch die Bewegung des Ventilators 4 wird die Luft in dem Kreiszylinder 6 in Rotation versetzt. Bedingt durch die Ausbildung des Filtersiebs 5 als Mantelfläche trifft die rotierende Luft nicht senkrecht auf das Filtersieb 5, sondern tangential. Dadurch wird in der Luft befindlicher Faserflug nicht gegen das Filtersieb 5 gepresst und bleibt damit nicht an dem Filtersieb 5 hängen, sondern wird weiter von der Luft mitgenommen und von dem Ventilator wegbewegt.

In dem dargestellten Ausführungsbeispiel ist die Grundfläche 8 als Öffnung ausgebildet. An die Öffnung 8 der kreiszylindrischen Anordnung 6 schließt sich ein Raum 9 an, in dem sich der Faserflug sammelt, ohne dass es zu einer Beeinträchtigung der Zuluft kommt. Die Achse 7 der kreiszylindrischen Anordnung 6 steht im dargestellten Ausführungsbeispiel in Aufstellungsposition des Schaltschrankes 1 senkrecht zur Erdoberfläche, so dass der Raum 9 unterhalb der kreiszylindrischen Anordnung 6 und der Öffnung 8 angeordnet ist. Der Raum 9 weist eine verschließbare Öffnung 10 auf. So ist sichergestellt, dass der Raum 9 geschlossen werden kann, wenn die Textilmaschine in Betrieb ist und der Ventilator 4 Luft fördert. Andererseits kann der Raum 9 geöffnet werden, um den Faserflug von Zeit zu Zeit zu entfernen.

In der Fig. 2 lassen sich die zwei Bereiche des Anbauelementes gut erkennen. Das ist zum einen der Bereich mit dem kreiszylindrischen Filtersieb 5. Dieser Bereich weist eine Öffnung 11 auf.

Das Anbauelement 12 wird mit der Öffnung 11 an die Seitenwand des Schaltschrankelementes 13 montiert. Die Öffnung 11 wird dabei so positioniert, dass sie die Öffnungen 14 an dem Schaltschrankelement 13 überdeckt, mittels derer der Luftaustausch zwischen dem Anbauelement 12 und dem Schaltschrankelement 13 erreicht wird. Der Raum 9 ist zur Seitenwand des Schaltschrankelementes 13 ebenfalls offen. Die Öffnung wird bei der Montage durch die Seitenwand des Schaltschrankelementes 13 geschlossen.

## Patentansprüche

1. Schaltschrank (1) für eine Textilmaschine zur Aufnahme von elektrischen Komponenten, aufweisend
eine Öffnung (2) für Zuluft,
eine Öffnung (3) für Abluft,
einen Ventilator (4) zur Zwangsförderung von Luft durch die Öffnung (2) für Zuluft in den Schaltschrank (1) und
ein Filtersieb (5) zur Reinigung der Zuluft,
**dadurch gekennzeichnet,**
**dass** das Filtersieb (5) als Mantelfläche einer kreiszylindrischen Anordnung (6) ausgebildet ist,
**dass** die Öffnung (2) für Zuluft im Bereich der Deckfläche dieser kreiszylindrischen Anordnung (6) angeordnet ist und
**dass** der Ventilator (4) im Bereich der Öffnung (2) für Zuluft so angeordnet und ausgebildet ist, dass er Luft aus dem Inneren der kreiszylindrischen Anordnung durch das Filtersieb (5) in den Schaltschrank (1) drückt und dass die Grundfläche (8) der kreiszylindrischen Anordnung (6) zumindest teilweise offen ist.

2. Schaltschrank (1) nach Anspruch 1, **dadurch gekennzeichnet, dass** das Filtersieb (5) in dem Schaltschrank (1) so angeordnet ist, dass die Achse (7) der kreiszylindrischen Anordnung (6) in der Betriebsstellung des Schaltschrankes (1) senkrecht verläuft und der Ventilator (4) am oberen Ende der kreiszylindrischen Anordnung (6) positioniert ist.

3. Schaltschrank (1) nach einem der Ansprüche 1 oder 2, **dadurch gekennzeichnet, dass** an die zumindest teilweise offene Grundfläche (8) der kreiszylindrischen Anordnung (6) ein Raum (9) zur Aufnahme von Faserflug angrenzt.

4. Schaltschrank (1) nach Anspruch 3, **dadurch gekennzeichnet, dass** der Raum (9) eine verschließbare Öffnung (10) aufweist.

5. Schaltschrank (1) nach einem der vorherigen Ansprüche, **dadurch gekennzeichnet, dass** der Schaltschrank (1) ein Schaltschrankelement (13) zur Aufnahme der elektrischen Komponenten und ein Anbauelement (12) aufweist, welches an einer Seitenwand des Schaltschrankelementes (13) montiert ist, wobei das Filtersieb (5) und der Ventilator (4) in dem Anbauelement (12) angeordnet sind.

6. Schaltschrank (1) nach Anspruch 5, **dadurch gekennzeichnet, dass** die Öffnung (3) für Abluft im Bereich des Schaltschrankelementes angeordnet ist.

7. Schaltschrank (1) nach Anspruch 6, **dadurch gekennzeichnet, dass** das Anbauelement (12) und das Schaltschrankelement (13) jeweils zueinander korrespondierende Öffnungen (11, 14) aufweist, durch die die durch das Filter (5) gedrückte Luft in das Schaltschrankelement (13) gelangt.

8. Anbauelement (12) zur Montage an eine Seitenwand eines Schaltschrankelementes (13) mit einem Filtersieb (5), das als Mantelfläche einer kreiszylindrischen Anordnung (6) ausgebildet ist, und mit einem Ventilator (4), der im Bereich der Deckfläche (2) der kreiszylindrischen Anordnung (6) angeordnet und so ausgebildet ist, dass er Luft aus dem Inneren der kreiszylindrischen Anordnung (6) durch das Filtersieb (5) nach außen drückt, **dadurch gekennzeichnet, dass** eine Seite des Anbauelementes (12) eine Öffnung (11) aufweist und das Anbauelement (12) mit dieser Seite an eine Seitenwand eines Schaltschrankelementes (13) montierbar ist und dass die Grundfläche (8) der kreiszylindrischen Anordnung (6) zumindest teilweise offen ist.

9. Anbauelement nach Anspruch 8, **dadurch gekennzeichnet, dass** an die zumindest teilweise offene Grundfläche (8) der kreiszylindrischen Anordnung (6) ein Raum (9) zur Aufnahme von Faserflug angrenzt.

10. Anbauelement nach Anspruch 9, **dadurch gekennzeichnet, dass** der Raum (9) eine verschließbare Öffnung (10) aufweist.

11. Anbauelement nach einem der Ansprüche 8 bis 10, **dadurch gekennzeichnet, dass** die Achse (7) der kreiszylindrischen Anordnung (6) parallel zu der Seite des Anbauelementes (12) positioniert ist, die an die Seitenwand eines Schaltschrankelementes (13) montierbar ist.

## Claims

1. Control cabinet (1) for a textile machine, for receiving electrical components, comprising
an opening (2) for inlet air,
an opening (3) for outlet air,
a fan (4) for the forced supply of air through the opening (2) for inlet air into the control cabinet (1), and
a filter sieve (5) for cleaning the inlet air,
**characterised in that**
the filter sieve (5) is designed as a shell surface of a circular cylindrical arrangement (6), the opening (2) for inlet air is arranged in the area of the top surface of this circular cylindrical arrangement (6), and
that the fan (4) in the area of the opening for inlet air is arranged and designed in such a way that it forces air from the interior of the circular cylindrical arrangement through the filter sieve (5) into the control cabinet (1), and that the base surface (8) of the circular cylindrical arrangement (6) is at least partly open.

2. Control cabinet (1) according to claim 1, **characterised in that** the filter sieve (5) in the control cabinet (1) is arranged in such a way that the axis (7) of the circular cylindrical arrangement (6) extends vertically in the operating position of the control cabinet (1), and the fan (4) is positioned at the upper end of the circular cylindrical arrangement (6).

3. Control cabinet (1) according to one of the claims 1 or 2, **characterised in that** a room (9) for receiving airborne fibres borders on the at least partly open base surface (8) of the circular cylindrical arrangement (6).

4. Control cabinet (1) according to claim 3, **characterised in that** the room (9) comprises a closable opening (10).

5. Control cabinet (1) according to one of the preceding claims, **characterised in that** the control cabinet (1) comprises a control cabinet element (13) for receiving the electrical components and an extension element (12), which is mounted on a side wall of the control cabinet element (13), wherein the filter sieve (5) and the fan (4) are arranged in the extension element (12).

6. Control cabinet (1) according to claim 5, **characterised in that** the opening (3) for outlet air is arranged in the area of the control cabinet element.

7. Control cabinet (1) according to claim 6, **characterised in that** the extension element (12) and the control cabinet element (13) each comprise openings (11, 14) that correspond to each other, through which the air pressed through the filter (5) reaches the control cabinet element (13).

8. Extension element (12) for mounting to a side wall of a control cabinet (13), with a filter sieve (5) designed as a shell surface of a circular cylindrical arrangement (6), and with a fan (4) that is arranged in the area of the top surface (2) of the circular cylindrical arrangement (6) and is designed in such a way that it presses air from the interior of the circular cylindrical arrangement (6) through the filter sieve (5) towards the outside,
**characterised in that**
a side of the extension element (12) comprises an opening (11), and the extension element (12) can be mounted to a side wall of a control cabinet element (13) with this side, and that the base surface (8) of the circular cylindrical arrangement (6) is at least partly open.

9. Extension element according to claim 8, **characterised in that** a room (9) for receiving airborne fibres borders on the at least partly open base surface (8) of the circular cylindrical arrangement (6).

10. Extension element according to claim 9, **characterised in that** the room (9) comprises a closable opening (10).

11. Extension element according to one of the claims 8 to 10, **characterised in that** the axis (7) of the circular cylindrical arrangement (6) is positioned parallel to the side of the extension element (12) that can be mounted on the side wall of a control cabinet (13).

## Revendications

1. Armoire de commande (1) pour une machine textile, destinée à recevoir des composants électriques, présentant
une ouverture (2) pour l'air entrant,
une ouverture (3) pour l'air sortant,
un ventilateur (4) pour le transport forcé d'air à travers l'ouverture (2) pour l'air entrant dans l'armoire de commande (1) et
un tamis filtrant (5) pour purifier l'air entrant,
**caractérisée en ce**
**que** le tamis filtrant (5) est réalisé sous la forme d'une surface périphérique d'un agencement cylindrique circulaire (6),
**que** l'ouverture (2) pour l'air entrant est disposée dans la zone de la surface supérieure de cet agencement cylindrique circulaire (6) et
**que** le ventilateur (4) est disposé dans la zone de l'ouverture (2) pour l'air entrant et conçu pour refouler l'air dans l'armoire de commande (1) à travers le tamis filtrant (5) et
**que** la surface de base (8) de l'agencement cylindrique circulaire (6) est au moins partiellement ouverte.

2. Armoire de commande (1) selon la revendication 1, **caractérisée en ce que** le tamis filtrant (5) est disposé dans l'armoire de commande (1) de façon que l'axe (7) de l'agencement cylindrique circulaire (6) s'étende verticalement dans la position de service de l'armoire de commande (1) et que le ventilateur (4) soit positionné à l'extrémité supérieure de l'agencement cylindrique circulaire (6).

3. Armoire de commande (1) selon l'une des revendications 1 ou 2, **caractérisée en ce qu'**une chambre (9) destinée à recevoir le duvet de fibres est adjacente à la surface de base (8) au moins partiellement ouverte de l'agencement cylindrique circulaire (6).

4. Armoire de commande (1) selon la revendication 3, **caractérisée en ce que** la chambre (9) présente une ouverture (10) pouvant être fermée.

5. Armoire de commande (1) selon l'une des revendications précédentes, **caractérisée en ce que** l'armoire de commande (1) présente un élément d'armoire de commande (13) destiné à recevoir les composants électriques et un élément rapporté (12) qui est monté sur une paroi latérale de l'élément d'armoire de commande (13), le tamis filtrant (5) et le ventilateur (4) étant disposés dans l'élément rapporté (12).

6. Armoire de commande (1) selon la revendication 5, **caractérisée en ce que** l'ouverture (3) pour l'air sortant est disposée dans la zone de l'élément d'armoire de commande.

7. Armoire de commande (1) selon la revendication 6, **caractérisée en ce que** l'élément rapporté (12) et l'élément d'armoire de commande (13) présentent des ouvertures (11, 14) se correspondant l'une à l'autre, à travers lesquelles l'air refoulé à travers le filtre (5) parvient dans l'élément d'armoire de commande (13).

8. Elément rapporté (12) destiné à être monté sur une paroi latérale d'un élément d'armoire de commande (13), comportant un tamis filtrant (5) qui est réalisé sous la forme d'une surface périphérique d'un agencement cylindrique circulaire (6), et un ventilateur (4) qui est disposé dans la zone de la surface supérieure (2) de l'agencement cylindrique circulaire (6) et conçu pour refouler l'air de l'intérieur de l'agencement cylindrique circulaire (6) vers l'extérieur à travers le tamis filtrant (5), **caractérisé en ce qu'**un côté de l'élément rapporté (12) présente une ouverture (11) et l'élément rapporté (12) peut être monté par ce côté sur une paroi latérale d'un élément d'armoire de commande (13) et que la surface de base (8) de l'agencement cylindrique circulaire (6) est au moins partiellement ouverte.

9. Elément rapporté selon la revendication 8, **caractérisée en ce qu'**une chambre (9) destinée à recevoir le duvet de fibres est adjacente à la surface de base (8) au moins partiellement ouverte de l'agencement cylindrique circulaire (6).

10. Elément rapporté selon la revendication 9, **caractérisée en ce que** la chambre (9) présente une ouverture (10) pouvant être fermée.

11. Elément rapporté selon l'une des revendications 8 à 10, **caractérisée en ce que** l'axe (7) de l'agencement cylindrique circulaire (6) est positionné parallèlement au côté de l'élément rapporté (12) qui peut être monté sur la paroi latérale d'un élément d'armoire de commande (13).
